# EUROPEAN PATENT APPLICATION

(11) **EP 2 637 337 A2**
(43) Date of publication of application: **11.09.2013**
(21) Application number: 13152681.6
(22) Date of filing: 25.01.2013
(51) Int. Cl.: H04L 1/00

(54) **Systems and methods for out of order data reporting**

(30) Priority: 05.03.2012 US 201213412492
(71) Applicant: LSI Corporation, Milpitas, CA 95035 (US)
(72) Inventor: Yang, Shaohua, San Jose, California 95129 (US); Zhang, Fan, Milpitas, California 95035 (US); Han, Yang, Sunnyvale, California 94087 (US)
(74) Representative: Ford, Esther Mary

(57) **Abstract**

The present inventions are related to systems and methods for data processing, the data processing system comprising: a data processing circuit operable to: receive a first, a second and a third received data set; wherein the first data set is received prior to the second data set, and the second data set is received prior to the third data set; apply a data processing algorithm to the first received data set to yield a first output data set, apply the algorithm to the second received data set to yield a second output data set, and apply the algorithm to the third received data set to yield a third output data set; and an out of order enabling circuit operable to assert an order indicator output to indicate the second output data set is out of order when the second output data set is provided before the first output data set.

## Description

### BACKGROUND OF THE INVENTION

The present inventions are related to systems and methods for data processing, and more particularly to systems and methods for out of order reporting of results from data processing.

Various data transfer systems have been developed including storage systems, cellular telephone systems, radio transmission systems. In each of the systems data is transferred from a sender to a receiver via some medium. For example, in a storage system, data is sent from a sender (i.e., a write function) to a receiver (i.e., a read function) via a storage medium. In some cases, the data processing function uses a variable number of iterations through a data detector circuit and/or data decoder circuit depending upon the characteristics of the data being processed. Depending upon a number of factors, different data sets require more or fewer iterations through the data detector circuit and/or the data decoder circuit. An output buffer is employed that allows for data sets to be assembled into a requested order before reporting to a requesting device. The size of the output buffer is directly related to the maximum number of iterations through the data detector circuit and/or the data decoder circuit. In some cases, the size of the buffer is such that a given data set cannot be processed long enough to converge resulting in a disruptive error.

Hence, for at least the aforementioned reasons, there exists a need in the art for advanced systems and methods for data processing.

### BRIEF SUMMARY OF THE INVENTION

According to a first aspect of the invention, there is provided a data processing system as set out in independent claim 1. According to a second aspect of the invention, there is provided a data processing system as set out in independent claim 9.

According to a third aspect of the invention, there is provided a method for out of order data reporting in a data processing system, as set out in independent claim 13.

Preferred embodiments are defined in the dependent claims.

### BRIEF DESCRIPTION OF THE DRAWINGS

A further understanding of the various embodiments of the present invention may be realized by reference to the figures which are described in remaining portions of the specification. In the figures, like reference numerals are used throughout several figures to refer to similar components. In some instances, a sub-label consisting of a lower case letter is associated with a reference numeral to denote one of multiple similar components. When reference is made to a reference numeral without specification to an existing sub-label, it is intended to refer to all such multiple similar components.

Fig. 1 shows a storage system including constrained out of order processing circuitry in accordance with various embodiments of the present invention;

Fig. 2 depicts a data transmission system including constrained out of order processing circuitry in accordance with one or more embodiments of the present invention;

Fig. 3 shows a data processing circuit including an out of order enabling circuit in accordance with some embodiments of the present invention;

Fig. 4 shows a host controller including out of order receiving circuitry in accordance with some embodiments of the present invention;

Figs. 5a-5b are flow diagrams showing a method for out of order data reporting in a data processing system in accordance with some embodiments of the present invention;

Fig. 6 is a flow diagram showing a method in accordance with some embodiments of the present invention for host controller processing of out of order data sets; and

Figs. 7a-7b are timing diagrams showing show two examples of data reporting that may occur in accordance with some embodiments of the present invention.

### DETAILED DESCRIPTION OF THE INVENTION

Embodiments are related to systems and methods for data processing, and more particularly to systems and methods for out of order reporting of results from data processing.

Various embodiments of the present invention provide data processing systems that include a data processing circuit and an out of order enabling circuit. The data processing circuit is operable to: receive a first received data set, a second received data set, and a third received data set; wherein the first data set is received prior to the second data set, and the second data set is received prior to the third data set; and apply a data processing algorithm to the first received data set to yield a first output data set, apply the data processing algorithm to the second received data set to yield a second output data set, and apply the data processing algorithm to the third received data set to yield a third output data set. The out of order enabling circuit is operable to assert an order indicator output to indicate the second output data set is out of order when the second output data set is provided before the first output data set.

In some instances of the aforementioned embodiments, the out of order enabling circuit is further operable to set a span value indicating a number of data sets between a previously provided data set and the second output data set. In some such instances, the out of order enabling circuit is further operable to assert an order indicator output to indicate the third output data set is in order when the third output data set is provided after the second output data set. In particular cases, the out of order enabling circuit is further operable to set the span value to zero when the third output data set is provided.

In various instances of the aforementioned embodiments, the out of order enabling circuit is further operable to enable a selected order for providing the first output data set, the second output data set, and the third output data set, wherein the selected order is selected from a group consisting of: in order, and out of order. In some such instances, the out of order enabling circuit is operable to select the selected order based upon a received input. In particular cases, the received input indicates a number of out of order sequences receivable by a host device. The number of out of order sequences receivable by a host device is zero the selected order is in order, and when the number of out of order sequences receivable by a host device is greater than zero the selected order is out of order.

Other embodiments of the present invention provide data processing systems that include a data processing circuit and a out of order enabling circuit. The data processing circuit is operable to: process a previous input data set to yield a previous output data set; and process a current input data set to yield a current output data set. The out of order enabling circuit operable to: assert an order indicator output to indicate the current output data set is being provided out of order; and provide a span value indicating a number of data sets between the previous input data set and the current input data set. In some instances of the aforementioned embodiments, the out of order enabling circuit is further operable to set the span value to zero when the previous input data set directly precedes the current input data set. In various instances of the aforementioned embodiments, the out of order enabling circuit is further operable to enable out of order reporting of the current output data set based at least in part on a received input. In some cases, the received input indicates a number of out of order data sets receivable by a host device. When the number of out of order data sets receivable by a host device is zero the out of order enabling circuit is operable to disable out of order reporting of the current output data set. When the number of out of order data sets receivable by a host device is greater than zero the out of order enabling circuit is operable to enable out of order reporting of the current output data set.

Yet other embodiments of the present invention provide methods for out of order data reporting in a data processing system. The methods include receiving a first received data set, a second received data set, and a third received data set. The first data set is received prior to the second data set, and the second data set is received prior to the third data set. The methods further include applying a data processing algorithm to the first received data set to yield a first output data set, applying the data processing algorithm to the second received data set to yield a second output data set, applying the data processing algorithm to the third received data set to yield a third output data set, enabling out of order reporting of the second output data set, providing the second output data set to a recipient circuit prior to providing the first output data set to the recipient circuit, and asserting an order indicator output to indicate the second output data set is out of order.

In some instances of the aforementioned embodiments, the methods further include providing a span value to the recipient circuit indicating a number of data sets between a previously provided data set and the second output data set. In some cases, the methods further include: asserting the order indicator output to indicate the third output data set is in order when the third output data set is provided after the second output data set; and setting the span value to zero when the third output data set is provided. In one or more instances of the aforementioned embodiments, enabling out of order reporting of the second output data set is done based upon a received input from the recipient circuit that indicates a non-zero number of out of order data sets receivable by the recipient circuit.

This summary provides only a general outline of some embodiments of the invention. Many other objects, features, advantages and other embodiments of the invention will become more fully apparent from the following detailed description, the appended claims and the accompanying drawings.

Embodiments are related to systems and methods for data processing, and more particularly to systems and methods for out of order reporting of results from data processing.

Various embodiments of the present invention provide for data processing that allows for constrained out of order result reporting. The constraint may be, for example, provided from a requesting host device and indicates a maximum number of out of order data sets that may be accepted. In such a case, the data processing circuitry does not allow for out of order result reporting unless the indicated maximum number of out of order data sets is greater than zero. Where the indicated maximum number of out of order data sets is greater than zero, the data processing circuitry only allows for out of order data reporting such that the number of out of order data sets can be contained in less than or equal to the number of buffers corresponding to the indicated maximum number of out of order data sets. Providing such constrained out of order data reporting allows for processing cycles to be applied to a given data set beyond what would be allowed where in order data reporting is required, and at the same time allows a limit on the complexity that must be supported by a requesting host.

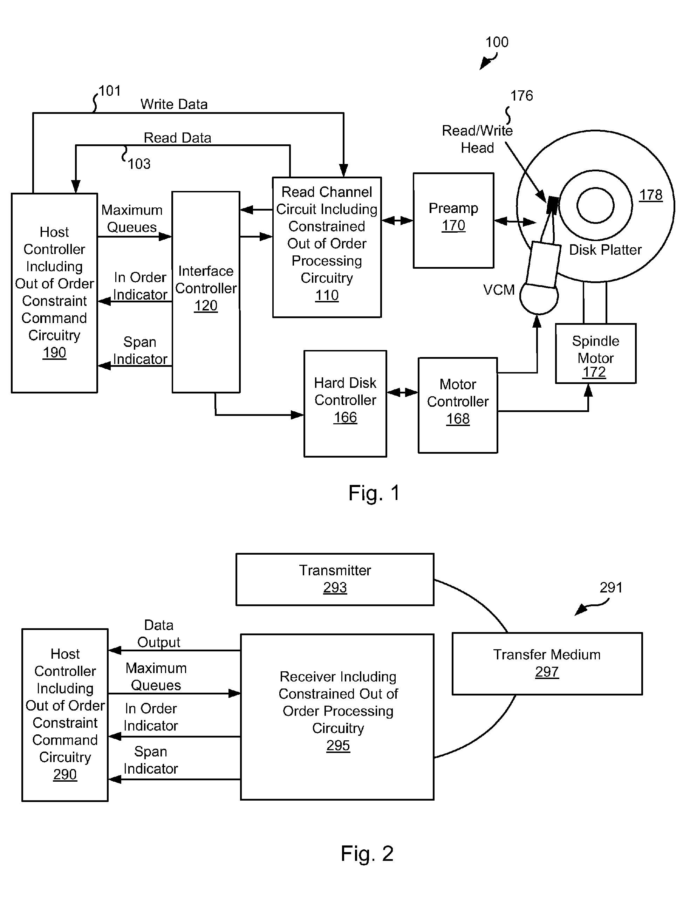

Turning to Fig. 1, a storage system 100 including a read channel circuit 110 having constrained out of order processing circuitry is shown in accordance with various embodiments of the present invention. Storage system 100 may be, for example, a hard disk drive. Storage system 100 also includes a preamplifier 170, an interface controller 120, a hard disk controller 166, a motor controller 168, a spindle motor 172, a disk platter 178, and a read/write head 176. Interface controller 120 controls addressing and timing of data to/from disk platter 178, and interacts with a host controller 190 that includes out of order constraint command circuitry. The data on disk platter 178 consists of groups of magnetic signals that may be detected by read/write head assembly 176 when the assembly is properly positioned over disk platter 178. In one embodiment, disk platter 178 includes magnetic signals recorded in accordance with either a longitudinal or a perpendicular recording scheme.

In a typical read operation, read/write head assembly 176 is accurately positioned by motor controller 168 over a desired data track on disk platter 178. Motor controller 168 both positions read/write head assembly 176 in relation to disk platter 178 and drives spindle motor 172 by moving read/write head assembly to the proper data track on disk platter 178 under the direction of hard disk controller 166. Spindle motor 172 spins disk platter 178 at a determined spin rate (RPMs). Once read/write head assembly 176 is positioned adjacent the proper data track, magnetic signals representing data on disk platter 178 are sensed by read/write head assembly 176 as disk platter 178 is rotated by spindle motor 172. The sensed magnetic signals are provided as a continuous, minute analog signal representative of the magnetic data on disk platter 178. This minute analog signal is transferred from read/write head assembly 176 to read channel circuit 110 via preamplifier 170. Preamplifier 170 is operable to amplify the minute analog signals accessed from disk platter 178. In turn, read channel circuit 110 decodes and digitizes the received analog signal to recreate the information originally written to disk platter 178. This data is provided as read data 103 to a receiving circuit. A write operation is substantially the opposite of the preceding read operation with write data 101 being provided to read channel circuit 110. This data is then encoded and written to disk platter 178.

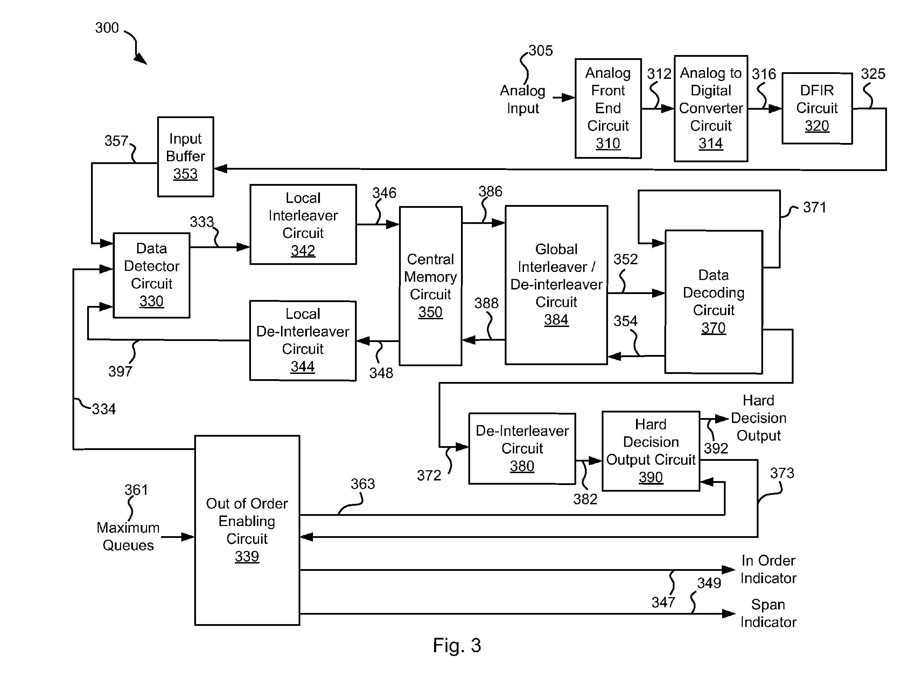

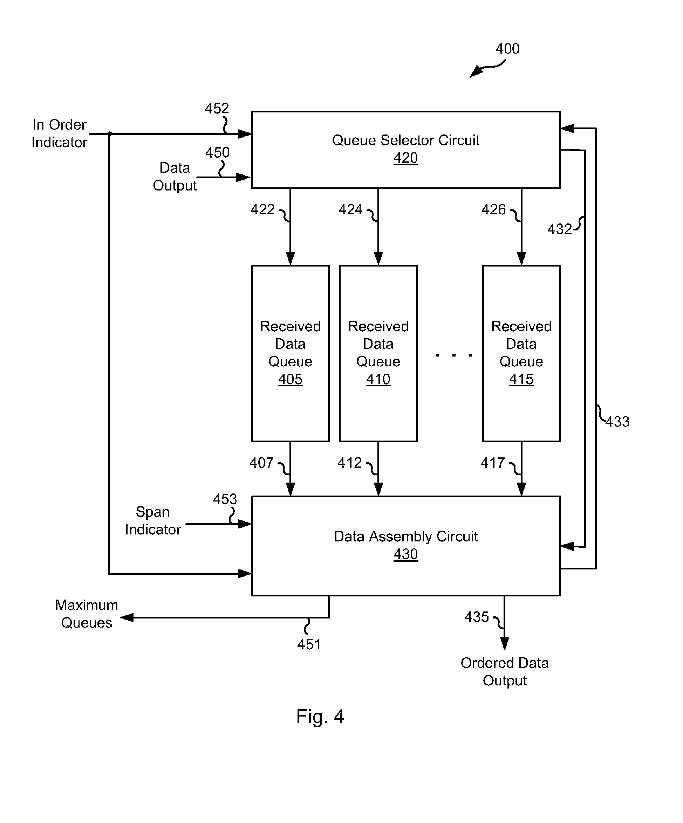

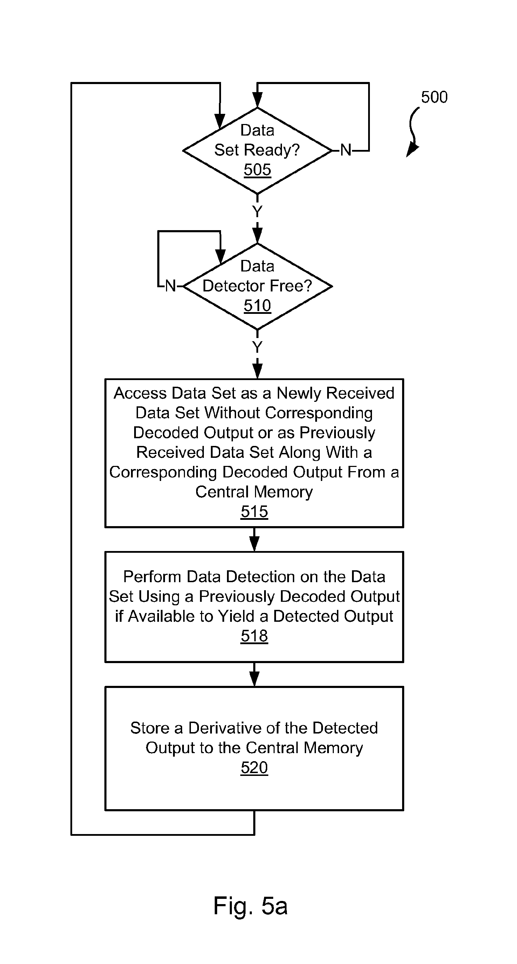

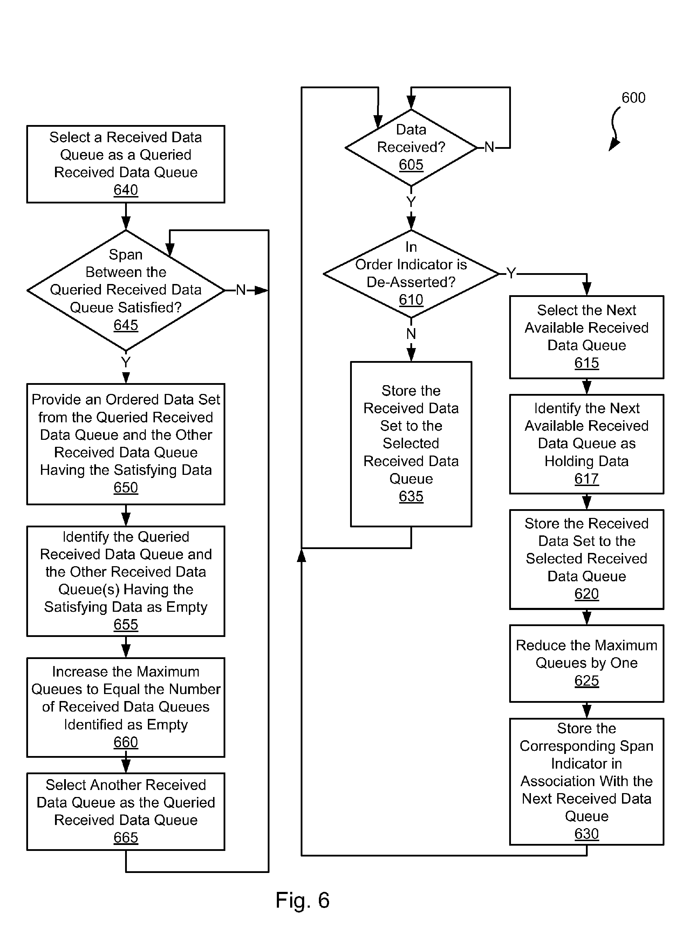

As part of processing the received information, read channel circuit 110 utilizes constrained out of order processing circuitry to determine whether results are reported to host controller 190 out of order, and if out of order reporting is allowed to what extent the out of order reporting is allowed. In some cases, read channel circuit 110 may be implemented to include a data processing circuit similar to that discussed below in relation to Fig. 3. Further, the data processing implemented by read channel circuit 110 may be implemented similar to that discussed below in relation to Figs. 5a-5b. In some cases, the reordering supported by host controller 190 may be implemented similar to that discussed below in relation to Fig. 4, and the reordering supported by host controller 190 may be implemented similar to that discussed below in relation for Fig. 6.

It should be noted that storage system 100 may be integrated into a larger storage system such as, for example, a RAID (redundant array of inexpensive disks or redundant array of independent disks) based storage system. Such a RAID storage system increases stability and reliability through redundancy, combining multiple disks as a logical unit. Data may be spread across a number of disks included in the RAID storage system according to a variety of algorithms and accessed by an operating system as if it were a single disk. For example, data may be mirrored to multiple disks in the RAID storage system, or may be sliced and distributed across multiple disks in a number of techniques. If a small number of disks in the RAID storage system fail or become unavailable, error correction techniques may be used to recreate the missing data based on the remaining portions of the data from the other disks in the RAID storage system. The disks in the RAID storage system may be, but are not limited to, individual storage systems such as storage system 100, and may be located in close proximity to each other or distributed more widely for increased security. In a write operation, write data is provided to a controller, which stores the write data across the disks, for example by mirroring or by striping the write data. In a read operation, the controller retrieves the data from the disks. The controller then yields the resulting read data as if the RAID storage system were a single disk.

A data decoder circuit used in relation to read channel circuit 110 may be, but is not limited to, a low density parity check (LDPC) decoder circuit as are known in the art. Such low density parity check technology is applicable to transmission of information over virtually any channel or storage of information on virtually any media. Transmission applications include, but are not limited to, optical fiber, radio frequency channels, wired or wireless local area networks, digital subscriber line technologies, wireless cellular, Ethernet over any medium such as copper or optical fiber, cable channels such as cable television, and Earth-satellite communications. Storage applications include, but are not limited to, hard disk drives, compact disks, digital video disks, magnetic tapes and memory devices such as DRAM, NAND flash, NOR flash, other nonvolatile memories and solid state drives.

Turning to Fig. 2, a data transmission system 291 including a receiver 295 having constrained out of order processing circuitry is shown in accordance with various embodiments of the present invention. Data transmission system 291 includes a transmitter 293 that is operable to transmit encoded information via a transfer medium 297 as is known in the art. The encoded data is received from transfer medium 297 by a receiver 295. Receiver 295 processes the received input to yield the originally transmitted data.

As part of processing the received information, receiver 295 utilizes constrained out of order processing circuitry to determine whether results are reported to host controller 290 out of order, and if out of order reporting is allowed to what extent the out of order reporting is allowed. In some cases, receiver 295 may be implemented to include a data processing circuit similar to that discussed below in relation to Fig. 3. Further, the data processing implemented by receiver 295 may be implemented similar to that discussed below in relation to Figs. 5a-5b. In some cases, the reordering supported by host controller 290 may be implemented similar to that discussed below in relation to Fig. 4, and the reordering supported by host controller 290 may be implemented similar to that discussed below in relation for Fig. 6.

Fig. 3 shows a data processing circuit 300 including an out of order enabling circuit 339 in accordance with some embodiments of the present invention. Data processing circuit 300 includes an analog front end circuit 310 that receives an analog signal 305. Analog front end circuit 310 processes analog signal 305 and provides a processed analog signal 312 to an analog to digital converter circuit 314. Analog front end circuit 310 may include, but is not limited to, an analog filter and an amplifier circuit as are known in the art. Based upon the disclosure provided herein, one of ordinary skill in the art will recognize a variety of circuitry that may be included as part of analog front end circuit 310. In some cases, analog signal 305 is derived from a read/write head assembly (not shown) that is disposed in relation to a storage medium (not shown). In other cases, analog signal 305 is derived from a receiver circuit (not shown) that is operable to receive a signal from a transmission medium (not shown). The transmission medium may be wired or wireless. Based upon the disclosure provided herein, one of ordinary skill in the art will recognize a variety of source from which analog input 305 may be derived.

Analog to digital converter circuit 314 converts processed analog signal 312 into a corresponding series of digital samples 316. Analog to digital converter circuit 314 may be any circuit known in the art that is capable of producing digital samples corresponding to an analog input signal. Based upon the disclosure provided herein, one of ordinary skill in the art will recognize a variety of analog to digital converter circuits that may be used in relation to different embodiments of the present invention. Digital samples 316 are provided to an equalizer circuit 320. Equalizer circuit 320 applies an equalization algorithm to digital samples 316 to yield an equalized output 325. In some embodiments of the present invention, equalizer circuit 320 is a digital finite impulse response filter circuit as are known in the art. It may be possible that equalized output 325 may be received directly from a storage device in, for example, a solid state storage system. In such cases, analog front end circuit 310, analog to digital converter circuit 314 and equalizer circuit 320 may be eliminated where the data is received as a digital data input. Equalized output 325 is stored to an input buffer 353 that includes sufficient memory to maintain one or more codewords until processing of that codeword is completed through a data detector circuit 330 and a data decoding circuit 370 including, where warranted, multiple global iterations (passes through both data detector circuit 330 and data decoding circuit 370) and/or local iterations (passes through data decoding circuit 370 during a given global iteration). An output 357 is provided to data detector circuit 330.

Data detector circuit 330 may be a single data detector circuit or may be two or more data detector circuits operating in parallel on different codewords. Whether it is a single data detector circuit or a number of data detector circuits operating in parallel, data detector circuit 330 is operable to apply a data detection algorithm to a received codeword or data set. In some embodiments of the present invention, data detector circuit 330 is a Viterbi algorithm data detector circuit as are known in the art. In other embodiments of the present invention, data detector circuit 330 is a is a maximum a posteriori data detector circuit as are known in the art. Of note, the general phrases "Viterbi data detection algorithm" or "Viterbi algorithm data detector circuit" are used in their broadest sense to mean any Viterbi detection algorithm or Viterbi algorithm detector circuit or variations thereof including, but not limited to, bi-direction Viterbi detection algorithm or bi-direction Viterbi algorithm detector circuit. Also, the general phrases "maximum a posteriori data detection algorithm" or "maximum a posteriori data detector circuit" are used in their broadest sense to mean any maximum a posteriori detection algorithm or detector circuit or variations thereof including, but not limited to, simplified maximum a posteriori data detection algorithm and a max-log maximum a posteriori data detection algorithm, or corresponding detector circuits. Based upon the disclosure provided herein, one of ordinary skill in the art will recognize a variety of data detector circuits that may be used in relation to different embodiments of the present invention. In some cases, one data detector circuit included in data detector circuit 330 is used to apply the data detection algorithm to the received codeword for a first global iteration applied to the received codeword, and another data detector circuit included in data detector circuit 330 is operable apply the data detection algorithm to the received codeword guided by a decoded output accessed from a central memory circuit 350 on subsequent global iterations.

Upon completion of application of the data detection algorithm to the received codeword on the first global iteration, data detector circuit 330 provides a detector output 333. Detector output 333 includes soft data. As used herein, the phrase "soft data" is used in its broadest sense to mean reliability data with each instance of the reliability data indicating a likelihood that a corresponding bit position or group of bit positions has been correctly detected. In some embodiments of the present invention, the soft data or reliability data is log likelihood ratio data as is known in the art. Detected output 333 is provided to a local interleaver circuit 342. Local interleaver circuit 342 is operable to shuffle sub-portions (i.e., local chunks) of the data set included as detected output and provides an interleaved codeword 346 that is stored to central memory circuit 350. Interleaver circuit 342 may be any circuit known in the art that is capable of shuffling data sets to yield a re-arranged data set. Interleaved codeword 346 is stored to central memory circuit 350.

Once a data decoding circuit 370 is available, a previously stored interleaved codeword 346 is accessed from central memory circuit 350 as a stored codeword 386 and globally interleaved by a global interleaver/de-interleaver circuit 384. Global interleaver/De-interleaver circuit 384 may be any circuit known in the art that is capable of globally rearranging codewords. Global interleaver/De-interleaver circuit 384 provides a decoder input 352 into data decoding circuit 370. In some embodiments of the present invention, the data decode algorithm is a low density parity check algorithm as are known in the art. Based upon the disclosure provided herein, one of ordinary skill in the art will recognize other decode algorithms that may be used in relation to different embodiments of the present invention. Data decoding circuit 370 applies a data decode algorithm to decoder input 352 to yield a decoded output 371. In cases where another local iteration (i.e., another pass trough data decoder circuit 370) is desired, data decoding circuit 370 re-applies the data decode algorithm to decoder input 352 guided by decoded output 371. This continues until either a maximum number of local iterations is exceeded or decoded output 371 converges.

Where decoded output 371 fails to converge (i.e., fails to yield the originally written data set) and a number of local iterations through data decoder circuit 370 exceeds a threshold, the resulting decoded output is provided as a decoded output 354 back to central memory circuit 350 where it is stored awaiting another global iteration through a data detector circuit included in data detector circuit 330. Prior to storage of decoded output 354 to central memory circuit 350, decoded output 354 is globally de-interleaved to yield a globally de-interleaved output 388 that is stored to central memory circuit 350. The global de-interleaving reverses the global interleaving earlier applied to stored codeword 386 to yield decoder input 352. When a data detector circuit included in data detector circuit 330 becomes available, a previously stored de-interleaved output 388 accessed from central memory circuit 350 and locally de-interleaved by a de-interleaver circuit 344. De-interleaver circuit 344 re-arranges decoder output 348 to reverse the shuffling originally performed by interleaver circuit 342. A resulting de-interleaved output 397 is provided to data detector circuit 330 where it is used to guide subsequent detection of a corresponding data set previously received as equalized output 325.

Alternatively, where the decoded output converges (i.e., yields the originally written data set), the resulting decoded output is provided as an output codeword 372 to a de-interleaver circuit 380. De-interleaver circuit 380 rearranges the data to reverse both the global and local interleaving applied to the data to yield a de-interleaved output 382. De-interleaved output 382 is provided to a hard decision output circuit 390. Hard decision output circuit 390 is operable to re-order data sets that may complete out of order back into their original order. The originally ordered data sets are then provided as a hard decision output 392.

In some cases, a recipient (not shown) of hard decision output 392 includes some ability to receive data sets out of order. This ability to receive data sets out of order is provided from the recipient device as a maximum queues input from the recipient. Where the maximum number of queues input 361 is zero it indicates that the recipient cannot accept data sets out of order as there is no extra buffering available. In such a case, an out of order enabling circuit 339 asserts an order enable output 363 to hard decision output circuit 390 such that out of order result reporting is disabled. In such a case, a completed data set remains in hard decision output circuit 390 until all previous data sets in a requested block of data have completed. When one or more data sets are in order in hard decision output circuit 390 they are provided to a recipient as hard decision output 392 and an order status signal 373 is asserted to out of order enabling circuit 339 indicating that data being reported is in order. As the in order data sets are being provided from hard decision output circuit 390 as hard decision output 392 to the recipient out of order enabling circuit 339 asserts an in order indicator 347 such that the recipient understands that the provided data is being provided in an ordered sequence. In addition, a span indicator 349 is set equal to zero by out of order enabling circuit 339. Setting span indicator 349 to zero indicates that there are no intervening data sets between the data sets provided as hard decision output 392.

In contrast, when maximum queues 361 is greater than zero it indicates that the recipient can accept at least one group of data sets out of order and is prepared with sufficient buffering to handle to additional out of order group(s). In such a case, an out of order enabling circuit 339 asserts order enable output 363 to hard decision output circuit 390 such that out of order result reporting is enabled. In such a case, a completed data set is immediately provided to the recipient from hard decision output circuit 390 as hard decision output 392. Where the next data set is to be provided from hard decision output circuit 390 as an out of order output, hard decision output circuit 390 asserts order status signal 373 to out of order enabling circuit 339 such that the out of order results are indicated. As the out of order data set is being provided from hard decision output circuit 390 as hard decision output 392 to the recipient, out of order enabling circuit 339 asserts in order indicator 347 such that the recipient understands that the provided data is being provided in an out of order sequence. In addition, a span indicator 349 is set equal to a number of data sets that are missing between the currently reported out of order data set and the previously reported data set. Alternatively, where the next data set is to be provided from hard decision output circuit 390 as an in order output, hard decision output circuit 390 asserts order status signal 373 to out of order enabling circuit 339 such that the in order results are indicated. As the in order data set is being provided from hard decision output circuit 390 as hard decision output 392 to the recipient, out of order enabling circuit 339 asserts in order indicator 347 such that the recipient understands that the provided data is being provided in an in order sequence. In addition, a span indicator 349 is set equal to zero by out of order enabling circuit 339. Setting span indicator 349 to zero indicates that there are no intervening data sets between the data sets provided as hard decision output 392.

Pseudocode describing the data reporting processes governed by hard decision output circuit 390 and out of order enabling circuit 339 is set forth below.

```
 If (Data Set Available in Hard Decision Output Circuit 390){
   If(Data Set is In Order From the Last Transferred Data Set){
    Provide Data Set as Hard Decision Output 392;
    Assert In Order Indicator 347 to indicate an in order transfer;
    Set Span Indicator 347 as Zero;
  }
  Else If(Data Set is Out of Order From the Last Transferred Data Set){
    If(Maximum Queues 361 is Equal to Zero){
      Hold the Data Set in the Hard Decision Output Circuit 390
     }
    Else If(Maximum Queues 361 is Greater than Zero) {
      Provide Data Set as Hard Decision Output 392;
      Assert In Order Indicator 347 to indicate an out of order transfer;
      Calculate a Number of Data Sets Between the Current Data Set and the Previously
      Transferred Data Set;
      Set Span Indicator 347 as the Calculated Number
     }
  }
 }
```

Turning to Fig. 4, depicts a host controller 400 operable to receive out of order data sets from, for example, a data processing system described above in relation to Fig. 3. Host controller 400 includes out of order receiving circuitry in accordance with some embodiments of the present invention. Host controller 400 includes a queue selector circuit 420 that receives a data output 450 and an in order indicator 452. Queue selector circuit 420 maintains a status of each of a number of received data queues 405, 410, 415 which indicates whether the respective ones of received data queues 405, 410, 415 are holding data sets or is empty. Based at least in part on this status and in order indicator 452, queue selector circuit 420 selects one of received data queues 405, 410, 415 to receive data output 450 via a respective queue input 422, 424, 426. In particular, where in order indicator 452 indicates that the current data set received as data output 450 is the next consecutive data set after the previous data set (i.e., the data set is in order), queue selector circuit 420 provides data output 450 to a currently selected one of received data queues 405, 410, 415. Alternatively, where in order indicator 452 indicates that the current data set received as data output 450 is not the next consecutive data set after the previous data set (i.e., the data set is out of order), queue selector circuit 420 selects one of the received data queues 405, 410, 415 that is identified as empty as the currently selected received data queues 405, 410, 415. This newly selected received data queue then receives data output 450 via a respective one of queue input 422, 424, 426. In addition, queue selector circuit 420 updates the status of the newly selected received data queue as holding data.

A data assembly circuit 430 receives the status of the received data queues 405, 410, 415 as a status input 432 from queue selector circuit 420. Based upon status input 432, data assembly circuit 430 sets the value of maximum queues 451. In particular, the value of maximum queues 451 is the number of received data queues 405, 410, 415 that are identified as empty. As such, a value of maximum queues 451 that is greater than zero indicates that at least one received data queue 405, 410, 415 is available to receive an out of order data transfer as data output 450.

In addition, data assembly circuit 430 receives a span indicator 453 that indicates a number of data sets that are missing between consecutive data set transfers via data output 450. Span indicator is non-zero when in order indicator 452 indicates that the currently received data set is out of order. Data assembly circuit 430 monitors the data maintained in the respective received data queues 405, 410, 415 along with the respective values of span indicator 453 indicating the missing data between respective ones of received data queues 405, 410, 415. When data assembly circuit 430 identifies one or more data sets in one or more received data queues 405, 410, 415, data assembly circuit accesses the identified received data queues to extract data sets in order via respective ones of outputs 407, 412, 417 and provides the ordered series of data sets as an ordered data output 435. This process results in emptying the identified received data queues which is indicated to queue selector circuit 420 via a status output 432. Based upon status output 432, queue selector circuit 420 updates the status of the respective received data queues 405, 410, 415 as empty. In addition, maximum queues 451 is updated to reflect the number of received data queues 405, 410, 415 that are empty.

It should be noted that while host controller 400 is shown as having a number of physical memories used as received data queues 405, 410, 415, that other implementations are possible in accordance with different embodiments of the present invention. As an example, received data queues 405, 410, 415 may be implemented as a number of pointers into a common memory that stores all of the data sets received as data output 450. Such an approach may offer a more efficient use a memory.

Figs. 5a-5b are flow diagrams 500, 501 showing a method for out of order data reporting in a data processing system in accordance with some embodiments of the present invention. Following flow diagram 500, it is determined whether a data set is ready for application of a data detection algorithm (block 505). In some cases, a data set is ready when it is received from a data decoder circuit via a central memory circuit. In other cases, a data set is ready for processing when it is first made available from a front end processing circuit. Where a data set is ready (block 505), it is determined whether a data detector circuit is available to process the data set (block 510).

Where the data detector circuit is available for processing (block 510), the data set is accessed by the available data detector circuit (block 515). The data detector circuit may be, for example, a Viterbi algorithm data detector circuit or a maximum a posteriori data detector circuit. Where the data set is a newly received data set (i.e., a first global iteration), the newly received data set is accessed. In contrast, where the data set is a previously received data set (i.e., for the second or later global iterations), both the previously received data set and the corresponding decode data available from a preceding global iteration (available from a central memory) is accessed. The accessed data set is then processed by application of a data detection algorithm to the data set (block 518). Where the data set is a newly received data set (i.e., a first global iteration), it is processed without guidance from decode data available from a data decoder circuit. Alternatively, where the data set is a previously received data set (i.e., for the second or later global iterations), it is processed with guidance of corresponding decode data available from preceding global iterations. Application of the data detection algorithm yields a detected output. A derivative of the detected output is stored to the central memory (block 520). The derivative of the detected output may be, for example, an interleaved or shuffled version of the detected output.

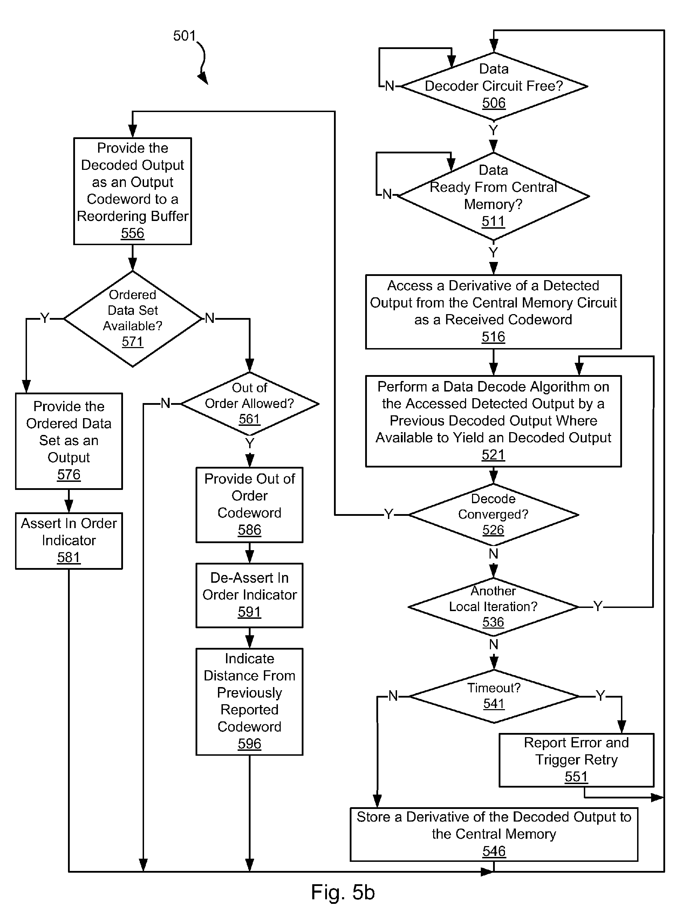

Following flow diagram 501 of Fig. 5b, it is determined whether a data decoder circuit is available (block 506) in parallel to the previously described data detection process of Fig. 5a. The data decoder circuit may be, for example, a low density parity check data decoder circuit as are known in the art. It is then determined whether a data set is ready from the central memory (block 511). The data set is a derivative of the detected output stored to the central memory as described above in relation to block 520 of Fig. 5a. Where a data set is available in the central memory (block 511), a previously stored derivative of a detected output is accessed from the central memory and used as a received codeword (block 516). A data decode algorithm is applied to the received codeword to yield a decoded output (block 521). Where a previous local iteration has been performed on the received codeword, the results of the previous local iteration (i.e., a previous decoded output) are used to guide application of the decode algorithm. It is then determined whether the decoded output converged (e.g., resulted in the originally written data as indicated by the lack of remaining unsatisfied checks) (block 526).

Where the decoded output converged (block 526), it is provided as a decoded output codeword to a reordering buffer (block 556). It is determined whether the received output codeword is either sequential to a previously reported output codeword in which case reporting the currently received output codeword immediately would be in order, or that the currently received output codeword completes an ordered set of a number of codewords in which case reporting the completed, ordered set of codewords would be in order (block 571). Where the currently received output codeword is either sequential to a previously reported codeword or completes an ordered set of codewords (block 571), the currently received output codeword and, where applicable, other codewords forming an in order sequence of codewords are provided to a recipient as an output (block 576). As the codeword(s) are provided as the output (block 576), an in order indicator is asserted such that the recipient is informed that the transferring codewords are in order (block 581).

Where, on the other hand, the currently received output codeword is not in order or does not render an ordered data set complete (block 571), it is determined whether out of order result reporting is allowed (block 561). This may be determined, for example, by determining whether the value of a maximum queues input is greater than zero. Where out of order result reporting is not allowed (block 561), the process resets to block 506. Alternatively, where out of order result reporting is allowed (block 561), the currently received output codeword is provided as an output to the recipient (block 586). As the codeword is provided as the output (block 586), in order indicator is de-asserted such that the recipient is informed that the transferring codeword is out of order (block 591). In addition, a number of output codewords between the previously reported output codeword and the currently received output codeword is calculated as a span indicator, and the span indicator is provided as a distance to the recipient (block 596).

Alternatively, where the decoded output failed to converge (e.g., errors remain) (block 526), it is determined whether another local iteration is desired (block 536). In some cases, as a default seven local iterations are allowed per each global iteration. Based upon the disclosure provided herein, one of ordinary skill in the art will recognize another default number of local iterations that may be used in relation to different embodiments of the present invention. Where another local iteration is desired (block 536), the processes of blocks 521, 526, 536 are repeated using the results of the previous local iteration as a guide for the next iteration.

Alternatively, where another local iteration is not desired (block 531), it is determined whether a timeout condition has been met (block 541). This timeout condition may be, for example, an indication that too little memory resources remain in either an input buffer or the central memory of the data processing system such that additional processing of the currently processing codeword is not possible. The amount of available space in the central memory and an output memory reordering queue is a function of how many iterations are being used by concurrently processing codewords to converge. For more detail on the output queue time limitation see, for example, US Pat. App. No. 12/114,462 entitled "Systems and Methods for Queue Based Data Detection and Decoding", and filed May 8, 2008 by Yang et al. The entirety of the aforementioned reference is incorporated herein by reference for all purposes. Thus, the amount of time that a codeword may continue processing through global iterations is a function of the availability of an input buffer, a central memory and an output memory reordering queue. Based upon the disclosure provided herein, one of ordinary skill in the art will recognize a variety of timeout conditions that may occur. Where a timeout condition is not met (block 541), additional processing of the currently processing codeword is allowed which is facilitated by writing a derivative of the decoded output to the central memory where it is maintained until a data detector is available to begin a subsequent global iteration (block 546). Alternatively, where a timeout condition is met (block 541) an error is reported and a retry of the currently processing codeword is triggered (block 551).

Turning to Fig. 6, a flow diagram 600 shows a method in accordance with some embodiments of the present invention for host processing of out of order data sets. Following flow diagram 600, it is determined whether a data set is being received from a data processing circuit (block 605). In one particular instance, a hard decision output 392 from data processing circuit 300 is received as a data output 450 in host controller 400. Where a data set is received (block 605), it is determined whether the in order indicator is de-asserted indicating that the currently received data set was received out of order (block 610). Where the in order indicator is de-asserted (block 610), the next available received data queue is selected (block 615). This may involve selecting any received data queue exhibiting an empty status. The status of the selected received data queue is identified as holding data (block 617), and the received data set is stored to the selected received data queue (block 620). The value of a maximum queues status output is reduced by one to indicate one less received data queue available for receiving additional information (block 625). Alternatively, where the in order indicator is asserted indicating the received data set is in order (block 610), the received data set is stored to the selected received data queue (block 635).

In parallel, one of the received data queues is selected as a queried received data queue (block 640). It is determined whether a span or distance between the first data set in the queried received data queue is satisfied by data maintained in one or more of the other received data queues (i.e., the data sets required to make a completed, ordered set of data sets) (block 645). Where the span is satisfied (block 645), the ordered data set from the queried received data queue and the other received data queue(s) that satisfy the span are provided as a completed, ordered set of data sets (block 650). In addition, the status of the queried received data queue and the other received data queue(s) that satisfy the span is updated to indicate empty (block 655), and the maximum queues is increased to equal the number of received data queues identified as empty (block 660). Another received data queues is selected as the queried received data queue (block 665), and the processes of blocks 640-665 are repeated.

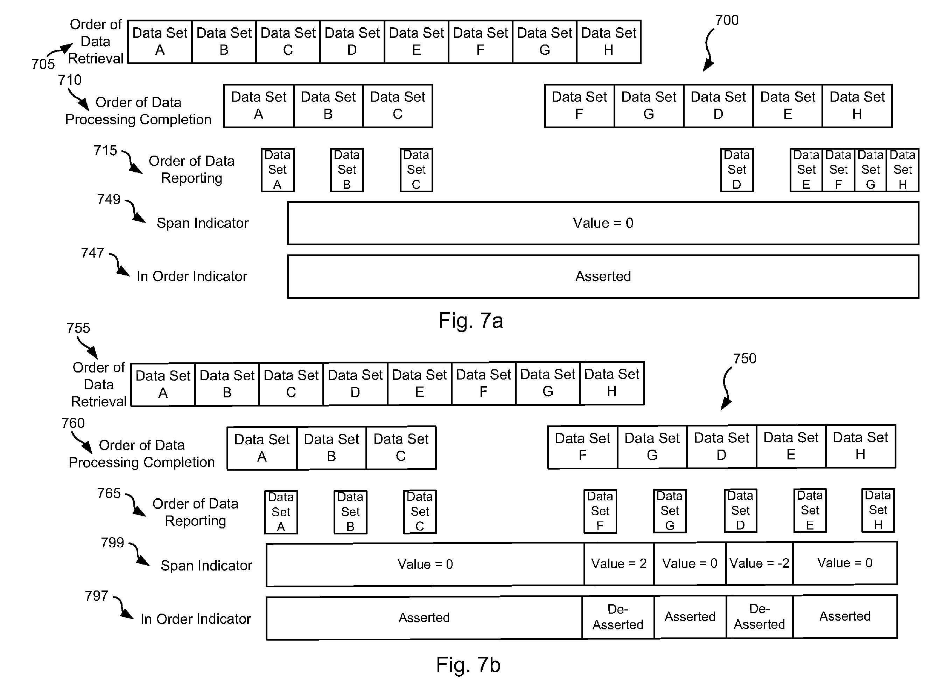

Turning to Fig. 7a, a timing diagram 700 shows an example data transfer from a storage medium to a receiving device. In particular, timing diagram 700 shows an number of data sets (i.e., data set A, data set B, data set C, data set D, data set E, data set F, data set G, and data set H) in an order of data retrieval 705 from a storage medium. The retrieved data sets are processed through a data processing circuit (e.g., data processing circuit 300) and are allowed to complete out of order. An order of data processing completion 710 is shown where data set D and data set E complete out of order. In the case of timing diagram 700, out of order reporting is not allowed. This may be caused by, for example, setting the value of a maximum queues signal (e.g., maximum queues 361, or maximum queues 451) to zero. In such a condition, the data sets are re-ordered in a hard decision output circuit included as part of the data processing circuit so that the data sets are reported in order. The in order reporting of data sets is shown as an order of data reporting 715. In such an in order reporting scenario, a span indicator 749 (e.g., span indicator 349 or span indicator 453) is always set equal to zero and an in order indicator 747 (e.g., in order indicator 347 or in order indicator 452) is always asserted indicating that all transfers are in order.

Turning to Fig. 7b, a timing diagram 700 shows an example data transfer from a storage medium to a receiving device. In particular, timing diagram 750 shows an number of data sets (i.e., data set A, data set B, data set C, data set D, data set E, data set F, data set G, and data set H) in an order of data retrieval 755 from a storage medium. The retrieved data sets are processed through a data processing circuit (e.g., data processing circuit 300) and are allowed to complete out of order. An order of data processing completion 760 is shown where data set D and data set E complete out of order. In the case of timing diagram 750, out of order reporting is allowed. This may be caused by, for example, setting the value of a maximum queues signal (e.g., maximum queues 361, or maximum queues 451) to greater than zero. In such a condition, the data sets are passed from a hard decision output circuit included as part of the data processing circuit almost as soon as they are ready in an out of order reporting order. The out of order reporting of data sets is shown as an order of data reporting 765. In such an out of order reporting scenario, a span indicator 799 (e.g., span indicator 349 or span indicator 453) is set equal to the number of data sets missing between consecutively reported data sets (e.g., it is set to zero when the currently reported data set is the next consecutive data set from the previously reported data set, and is set equal to two when two data sets are missed between the currently reported data set and the previously reported data set). An in order indicator 797 (e.g., in order indicator 347 or in order indicator 452) is asserted when the currently reported data set is the next consecutive data set from the previously reported data set, and de-asserted when the currently reported data set is not the next consecutive data set from the previously reported data set.

It should be noted that the various blocks discussed in the above application may be implemented in integrated circuits along with other functionality. Such integrated circuits may include all of the functions of a given block, system or circuit, or a subset of the block, system or circuit. Further, elements of the blocks, systems or circuits may be implemented across multiple integrated circuits. Such integrated circuits may be any type of integrated circuit known in the art including, but are not limited to, a monolithic integrated circuit, a flip chip integrated circuit, a multichip module integrated circuit, and/or a mixed signal integrated circuit. It should also be noted that various functions of the blocks, systems or circuits discussed herein may be implemented in either software or firmware. In some such cases, the entire system, block or circuit may be implemented using its software or firmware equivalent. In other cases, the one part of a given system, block or circuit may be implemented in software or firmware, while other parts are implemented in hardware.

In conclusion, embodiments of the invention provide novel systems, devices, methods and arrangements for out of order data processing. While detailed descriptions of one or more embodiments of the invention have been given above, various alternatives, modifications, and equivalents will be apparent to those skilled in the art without varying from the spirit of the invention. Therefore, the above description should not be taken as limiting the scope of the invention, which is defined by the appended claims.

## Claims

1. A data processing system, the data processing system comprising:
a data processing circuit operable to:
receive a first received data set, a second received data set, and a third received data set; wherein the first data set is received prior to the second data set, and the second data set is received prior to the third data set;
apply a data processing algorithm to the first received data set to yield a first output data set, apply the data processing algorithm to the second received data set to yield a second output data set, and apply the data processing algorithm to the third received data set to yield a third output data set; and
an out of order enabling circuit operable to assert an order indicator output to indicate the second output data set is out of order when the second output data set is provided before the first output data set.

2. The data processing system of claim 1, wherein the out of order enabling circuit is further operable to set a span value indicating a number of data sets between a previously provided data set and the second output data set.

3. The data processing system of any preceding claim, wherein:
the out of order enabling circuit is further operable to assert the order indicator output to indicate the third output data set is in order when the third output data set is provided after the second output data set; and/or
the out of order enabling circuit is further operable to set the span value to zero when the third output data set is provided.

4. The data processing system of any preceding claim, wherein the out of order enabling circuit is further operable to enable a selected order for providing the first output data set, the second output data set, and the third output data set, wherein the selected order is selected from a group consisting of: in order, and out of order.

5. The data processing system of claim 4, wherein:
the out of order enabling circuit is operable to select the selected order based upon a received input; and/or
the received input indicates a number of out of order data sets receivable by a host device, wherein when the number of out of order data sets receivable by a host device is zero the selected order is in order, and wherein when the number of out of order data sets receivable by a host device is greater than zero the selected order is out of order.

6. The data processing system of any preceding claim, wherein the system is implemented as part of a storage device, and wherein the storage device comprises:
a storage medium holding a first stored data set, a second stored data set, and a third stored data set; and
a data sensing device operable to: sense the first stored data set and to provide the corresponding first received data set, sense the second stored data set and to provide the corresponding second received data set, and sense the third stored data set and to provide the corresponding third received data set.

7. The data processing system of any preceding claim, wherein:
the system is implemented as part of a communication device; and/or
the system is implemented as an integrated circuit.

8. The data processing system of any preceding claim, wherein the data processing circuit includes a data detector circuit and a data decoder circuit, and wherein the data processing algorithm is a combination of a data detection algorithm and a data decode algorithm, preferably wherein:
the data detector circuit is selected from a group consisting of: a Viterbi algorithm data detector circuit, and a maximum a posteriori data detector circuit; and/or
the data decoder circuit is a low density parity check decoder circuit.

9. A data processing system, the data processing system comprising:
a data processing circuit operable to:
process a previous input data set to yield a previous output data set; and
process a current input data set to yield a current output data set;
an out of order enabling circuit operable to:
assert an order indicator output to indicate the current output data set is being provided out of order; and
provide a span value indicating a number of data sets between the previous input data set and the current input data set.

10. The data processing system of claim 9, wherein the out of order enabling circuit is further operable to set the span value to zero when the previous input data set directly precedes the current input data set.

11. The data processing system of claim 9 or 10, wherein the out of order enabling circuit is further operable to enable out of order reporting of the current output data set based at least in part on a received input,
preferably wherein the received input indicates a number of out of order data sets receivable by a host device, wherein when the number of out of order data sets receivable by a host device is zero the out of order enabling circuit is operable to disable out of order reporting of the current output data set, and wherein when the number of out of order data sets receivable by a host device is greater than zero the out of order enabling circuit is operable to enable out of order reporting of the current output data set.

12. The data processing system of any one of claims 9 to 11, wherein:
the system is implemented as part of a device selected from a group consisting of: a storage device, and a communication device; and/or
the system is implemented as an integrated circuit.

13. A method for out of order data reporting in a data processing system, the method comprising:
receiving a first received data set, a second received data set, and a third received data set; wherein the first data set is received prior to the second data set, and the second data set is received prior to the third data set;
applying a data processing algorithm to the first received data set to yield a first output data set;
applying the data processing algorithm to the second received data set to yield a second output data set;
applying the data processing algorithm to the third received data set to yield a third output data set;
enabling out of order reporting of the second output data set;
providing the second output data set to a recipient circuit prior to providing the first output data set to the recipient circuit; and
asserting an order indicator output to indicate the second output data set is out of order.

14. The method of claim 13, wherein:
the method further comprises providing a span value to the recipient circuit indicating a number of data sets between a previously provided data set and the second output data set; and/or
the method further comprises:
asserting the order indicator output to indicate the third output data set is in order when the third output data set is provided after the second output data set; and
setting the span value to zero when the third output data set is provided.

15. The method of any one of claims 13 and 14, wherein enabling out of order reporting of the second output data set is done based upon a received input from the recipient circuit that indicates a non-zero number of out of order data sets receivable by the recipient circuit.
